# EUROPEAN PATENT SPECIFICATION

(11) **EP 2 392 197 B1**
(45) Date of publication and mention of the grant of the patent: **19.11.2014**
(21) Application number: 10704581.7
(22) Date of filing: 02.02.2010
(51) Int. Cl.: B41M 5/52, H01L 51/00, H05K 1/03, H01L 51/05

(54) **METHOD FOR CREATING A SUBSTRATE FOR PRINTED OR COATED FUNCTIONALITY, SUBSTRATE AND ITS USE**
VERFAHREN ZUR ERZEUGUNG EINES SUBSTRATS FÜR GEDRUCKTE ODER BESCHICHTETE FUNKTIONALITÄT, SUBSTRAT UND VERWENDUNG DAFÜR
PROCÉDÉ PERMETTANT DE CRÉER UN SUBSTRAT POUR UNE FONCTIONNALITÉ IMPRIMÉE OU ENROBÉE, SUBSTRAT ET SON UTILISATION

(30) Priority: 02.02.2009 FI 20095089
(43) Date of publication of application: 07.12.2011
(73) Proprietor: Åbo Akademi University, 20500 Åbo (FI)
(72) Inventor: BOLLSTRÖM, Roger, FI-20500 Turku (FI); MÄÄTTÄNEN, Anni, FI-20520 Turku (FI); IHALAINEN, Petri, FI-20610 Turku (FI); TOIVAKKA, Martti, FI-20540 Turku (FI); PELTONEN, Jouko, FI-20610 Turku (FI)
(74) Representative: Turun Patenttitoimisto Oy
(86) International application number: PCT/FI2010/050056
(87) International publication number: WO 2010/086511

(56) References cited:
- EP-A2- 0 605 840
- GB-A- 2 410 705
- US-A1- 2003 152 752
- US-A1- 2003 211 293
- US-A1- 2006 006 378
- US-A1- 2006 159 838
- US-A1- 2006 160 373
- US-A1- 2008 090 033
- US-A1- 2008 117 238

## Description

The present invention relates to a method for creating a substrate for printed or coated functionality, a substrate and its use according to the preambles of the enclosed claims.

### BACKGROUND OF INVENTION

One of the trends in the flexible display and sensor technology is to develop low-cost disposable or throwaway electronics. These disposable or throwaway electronics require devices with reasonable electrical performance and practically negligible production cost. An interesting alternative for fabrication for low-cost electronics would be printing the electronic circuits by using conducting inks on a substrate. Flexible polymer film based substrates based on polyethylene naphthalate (PEN) and polyethylene terephthalate (PET) have been employed in fabrication of printable electronic circuits.

A cheap substrate alternative would be paper or board. However, the conventional paper substrate suffers from wet process and heat treatments that are needed during the circuit manufacture. When printing with conducting or semiconducting materials on a paper substrate changes in temperature and humidity affect the conductivity of the final print. Different solvents that are needed in conducting printing liquids and inks for printing electronic circuits are also easily absorbed by the paper. Solvent absorption causes spreading of the printing result, rendering it unusable.

Paper substrates have been laminated with barrier sheets in order to improve their general resistance against humidity, water and/or organic solvents. A problem with polymer substrates and laminated paper substrates has been a poor printability due to low surface energy of the substrate. Poor printability means bleeding with methods employing rotating printing or ink only staying as drops on the substrate surface when methods employing inkjet printing are used. Surface energy may be modified by treating the surface with electron beam or with plasma, these however may have negative effects on the barrier properties, especially the corona treatment.

Some prior art is disclosed in EP 0605840 and GB 2410705.

EP 0605840 discloses an ink jet recording sheet which comprises a support mainly composed of wood fibers, an ink-receiving layer provided on one side of the support and an adhesive layer provided on another side of the support. A barrier layer, which comprises film-forming material is provided between the support and the ink-receiving layer and/or between the support and the adhesive layer. Penetration of the adhesive into the ink-receiving layer is thus prevented:

GB 2410705 discloses an inkjet recording material, which comprises a substrate coated with an ink receiving composition. The substrate may be non absorbent, such as a resin coated or barrier coated paper. The ink receiving composition comprises silica, a water soluble acrylate and a basic polymer. The substrate may be treated eg. by corona discharge or by application of a primer layer, to improve adhesion of the coating. US-A1-2006/159 838 teaches means for controlling ink migration during formation of printable electronic features.

### OBJECT AND SUMMARY OF THE INVENTION

An object of this invention is to minimise or even eliminate the disadvantages existing in the prior art.

A further object is to provide a simple and easy method for creating a paper based substrate for printed or coated functionality.

A further object is also to provide a cheap substrate for functional devices, such as electronic circuits.

Still further object is also to provide a method suitable for reel-to-reel or roll-to-roll manufacturing of a substrate.

These objects are attained with the invention having the characteristics presented below in the characterising parts of the independent claims.

Typical method according to the present invention for creating a substrate for printed or coated functionality is disclosed in claim 1.The method comprises i.a.
- obtaining a base web substrate comprising cellulose and/or wood fibres,
- coating the base web substrate with a barrier layer, and
- coating the barrier layer with a top coat layer comprising pigment particles.

Typical substrate according to the present invention for printed or coated functionality is disclosed in claim 8. The substrate comprisese i.a.
- a base web substrate layer comprising cellulose and/or wood fibres,
- a barrier layer, coated on the base web substrate layer,
- a top coat layer comprising mineral and/or pigment particles, coated on the barrier layer.

Typical functional deviceis printed or coated to the substrate according to the present invention by using printing, such as inkjet printing, flexographic printing, pad printing, rotogravure printing, offset printing, screen printing, or coating, such as reverse gravure coating, blade coating rod coating, dip coating, drop coating, curtain coating, spray coating, spin coating or embossing.

Now it has been found out that by coating a barrier layer between the base web substrate and a thin top coat layer comprising mineral particles, the absorption of conducting printing ink to the base web substrate can be prevented, and at the same time an optimal printing results can be achieved. The top coat layer makes the surface easily printable, and problems, e.g. bleeding, are minimised. The present invention enables the use of cheap fibrous substrates, such as paper and board for use in printable electronic circuit manufacturing.

The base web substrate may be any coatable web substrate comprising fibres originating from the nature, such as cellulose and/or wood fibres. The base web surface may include super calendered (SC) paper, ultralight weight coated (ULWC) paper, light weight coated (LWC) paper, medium weight coated (MWC) paper, heavy weight coated (HWC) paper, machine finished coated (MFC) paper, film coated offset (FCO) paper, woodfree coated (WFC) paper, light weight coated (LWCO) printing paper, SC offset (SCO) printing paper, machine finished specialties (MFS), copy paper or newsprint paper, but not limited to these. Typical coated magazine paper, such as LWC, comprises mechanical pulp around 40 - 60 weight-%, bleached softwood pulp around 25 - 40 weight-% and fillers and/or coating agents around 20 - 35 weight-%. SC paper comprises mechanical pulp around 70 - 90 weight-% and long fibered cellulose pulp around 10 - 30 %. Typical grammage values for different paper grades may be: 40 - 80 g/m² for SC, 40 - 70 g/m² for LWC, 70-130 g/m² for MWC, 50 - 70 g/m² for MFC, 40-70 g/m² for FCO, 70-90 g/m² for MWC, 100-135 g/m² for HWC, 80 - 140 g/m² for WFC.

The base web substrate may comprise also recycled fibres. For example, MFS paper grades are uncoated papers made of mechanical fibres and also at least partly of recycled fibres.

The base web substrate may also be a paperboard like folding boxboard (FBB), white lined chipboard (WLC), solid bleached sulphate (SBS) board, solid unbleached sulphate (SUS) board or liquid packaging board (LPB), but not limited to these. Boards may have grammage from 120 to 500 g/m² and they may be based 100 % on primary fibres, 100 % on recycled fibres, or to any possible blend between primary and recycled fibres.

When the base web substrate is a normal paper or board, it is easily recyclable in normal waste paper plants, and it can be collected from consumers by using existing waste collection systems.

The base web substrate may be obtained as a ready pre-coated customer reel from a paper mill comprising a pre-coat layer: According to one embodiment of the invention the base web substrate may be coated with a pre-coat layer before coating it with the barrier layer, i.e. all the coating steps may be performed successively one after another. The pre-coat layer comprises typically coarse mineral and/or pigment particles, such as ground calcium carbonate, kaolin, precipitated calcium carbonate or talc. The particles may typically have an average size of over 1 micron, measured by sedimentation, but the particle size of the mineral/pigment employed is not a critical factor. Coarse particles are preferred for economical reasons. The pre-coat layer may be obtained by surface sizing, possibly by using a pigmented surface size, i.e. a surface size comprising pigment particles. The coat weight may be 1.0 to 2.0 g/m².

According to one embodiment of the invention it is possible to coat a smoothing layer between the barrier layer and the preceding layer, which may be the pre-coat layer. In other words, a smoothing layer may be coated to the base web substrate comprising a pre-coat layer. The smoothing layer comprises fine mineral and/or pigment particles, such as calcium carbonate, kaolin, calcinated kaolin, talc, titanium dioxide, gypsum, chalk, satine white, barium sulphate, sodium aluminium silicate, aluminium hydroxide or any of their mixture. The mineral/pigment particles may typically have an average size less than 1 micron, measured by sedimentation.

The smoothing layer may be obtained by surface sizing. The thickness of the smoothing layer is typically 3 - 7 µm, depending on the preceding layer and the base web substrate. The function of the smoothing layer is to smooth and even out the surface to which the barrier layer is to be coated in order to guarantee the improved printing properties for the final product. If the surface of the base web substrate is inherently smooth or the surface is rendered smooth by pre-coating, the smoothing layer may be thin or it may be totally omitted. Smoothing layer is thus not necessary, but it may improve printing properties of the final substrate. Typical coating amount for smoothing layer is about 3 - 15 g/m².

The barrier layer comprises typically latex or polyolefin dispersion. Typical synthetic latexes that may be used in the present invention are latexes known in the art, such as styrene butadiene (SB), styrene acrylate (SA), polyvinyl alcohol or polyvinyl acetate (PVAc) latex, or any of their mixtures. Preferably the latex is styrene acrylic copolymer latex or styrene butadiene latex. Typical polyolefin dispersions are water based dispersions that may be obtained by using mechanical dispersion technology. The polyolefin dispersion may have high solids content, i.e. 40 - 55 weight-% solids, and the average particle diameter may be less than 1 micron. Suitable polyolefins are ethylene and propylene copolymers

According to one preferable embodiment the barrier layer comprises latex and mineral and/or pigment particles, which increase the surface energy of the barrier layer. Increase of the surface energy of the barrier layer improves the adhesion of the top coat layer to the barrier layer. The mineral/pigment particles employed may be the same as used in the top coat layer, i.e. kaolin, precipitated calcium carbonate (PCC), ground calcium carbonate (GCC), talc, mica or mixtures thereof comprising two or more of the said minerals/pigments. Typically the amount of mineral/pigment particles in the barrier layer is 0 - 85 weight-%, more typically 0.1 - 50 weight-%. Especially, when platy pigments, such as kaolin, talc or mica, which have an aspect ratio in the range of 50 - 150, preferably around 100, are used, the amount of the pigment in the barrier layer may be > 50 weight-%, for example 50 - 85 weight-%. The aspect ratio of a particle describes the ratio between the particle length to the particle broadness, i.e. the aspect ratio may be given as the ratio between the longest and shortest dimensions of the particle and is defined more specifically as the ratio of the longest and shortest particle radii that pass through the geometric centre of the particle. By increasing the amount of pigment and/or mineral particles in the barrier layer, the weight and thickness of the barrier layer may be easily controlled according to the relevant needs. It is also possible to control permeability, porosity, surface energy and surface topography of the barrier layer by adjusting the amount of mineral/pigment particles in the barrier layer.

The thickness of the barrier layer is typically 1 - 25 µm, preferably 2 - 10 µm. The coating amount is typically 0.5 - 30 g/m².

According to the invention a thin top coat layer is coated on the barrier layer, preferably in direct contact with it. The top coat layer comprises mineral and/or pigment particles in order to improve the printability of the final substrate, and advantageously the top coat layer is as thin and smooth as possible. Typical minerals/pigments that may be used in the top coat layer are calcium carbonate, kaolin, calcinated kaolin, talc, titanium dioxide, gypsum, chalk, satine white, barium sulphate, sodium aluminium silicate, aluminium hydroxide or any of their mixture, kaolin or precipitated calcium carbonate (PCC) being preferred. Typically the amount of mineral/pigment particles in the top coat layer is 60 - 100 weight-%, more typically 85 - 95 weight. The minerals/pigments in the top coat layer may be blended with latex, such as styrene butadiene latex, styrene-n-butyl-acrylate latex, polyvinyl acrylate latex, polyvinyl alcohol latex, polyvinyl acetate latex, or any of their mixtures. Alternatively, the minerals/pigments in the top coat layer may be blended with polyolefin dispersion. Top coat layer may also be coated in two or several steps, i.e. the top coat layer may comprise two or more sub-layers that have been coated on top of each other.

Typically the thickness of the top coat layer is 0.4 - 15 µm, more typically 0.7 - 10 µm. The coating amount is typically 0.5 - 15 g/m², more typically 0.7 - 8 g/m².

The top coat layer may comprise same components than the barrier layer, but the top coat layer and barrier layer are different from each other at least by their physical properties, and often also by their chemical composition. At least the surface energies of the top coat layer and the barrier layer are different from each other. If the top coat layer and barrier layer comprise the same components, the proportions of the components to each other are different in the different layers.

In one embodiment of the invention it is possible to use alcohol instead of water as dispersing medium for top coat layer. This may improve or enable the coating of the top coat layer on the barrier layer in those cases when the barrier layer has a low surface energy and is very hydrophobic.

An advantage of the present invention is that the materials used for creating the printable substrate are widely used bulk chemicals for paper production and coating. In principle, normal industrial-grade chemicals from any supplier and having the required properties can be used in the invention when building up the printable substrate. This means that it is not necessary to use expensive and/or tailor-made chemical for obtaining a substrate suitable for printing an electrical circuit.

According to one embodiment of the invention it is possible to control the printing properties of the finished substrate by controlling the thickness and porosity of the top coat layer. In other words, it is possible to adjust the amount of conducting or semi-conducting printing colour or ink by controlling the thickness and porosity of the top coat layer. The printed colour or ink penetrates into the top coat layer but stops at the barrier layer. If the top coat layer is thick or porous, more printing colour is absorbed by it, and stronger conducting properties are obtained.

It is also possible to control the printing properties of the final substrate by proper selection of the mineral/pigment type, quality and amount in the top coat layer and/or in the barrier layer. For example, print quality, print resolution and ink adhesion may be adjusted by selection of the pigment particles which are used in the top coat layer, whereby porosity, pore geometry, permeability, surface energy and roughness of the top coat layer are influenced. For example, top coat layers comprising precipitated calcium carbonate (PCC) particles are typically more porous and rougher than top coat layers comprising kaolin particles. The top coat layer comprising PCC particles show therefore usually a sharper print resolution as the spreading of the drop is prevented by increasing roughness. When the printed functional ink can penetrate into the top coat layer but not into the barrier layer it is the thickness of the top coat layer that determines the amount of ink needed to form a full film upon the substrate. The ink amount needed is typically higher for porous top coat layer comprising PCC particles than for packed and compact top coat layers comprising kaolin particles.

The surface energy of the barrier layer may be controlled by adjusting the amount, type and/or quality of mineral/pigment particles in the barrier layer. The surface energy of the barrier layer may be used to improve or enable the attachment of the top coat layer to the surface of the barrier layer. It may also be used to control the spreading of the functional printing ink on the barrier layer surface, after the ink has penetrated the top coat layer and reached the surface of the barrier layer.

According to one embodiment of the invention the coating of the different layers is performed as blade coating, rod coating, reverse gravure coating or curtain coating. This means that the different layers may be coated to the base web substrate by using conventional roll-to-roll or reel-to-reel coating methods, which makes the substrate manufacture easy and cost-effective. These coating methods enable production of large amounts of substrate at low cost, which is important when making disposable electronic circuits or printed functional devices. According to one embodiment of the invention channels, well structures or the like may be embossed to the substrate, typically by using hot embossing. This is especially suitable for making sensors, where it is desired that the analyte will stay in certain part of the substrate or to flow through the sensor certain defined manner. It is possible to attach organic and/or inorganic reagent or reactant, such as an enzyme or indicator. The attachment can be done e.g. by printing or coating the reagent or reactant to the channel or well.

It is possible to calender the substrate after coating of the top coat layer in order to improve the attachment of the top coat layer to the barrier layer and to avoid possible picking problems. At the same time a high smoothness may be achieved. The coated substrate may be calendered by using different line loads, such as 50 - 300 kN/m. Calendering may be performed at an elevated temperature, e.g. 40-200 °C Several calendering nips may be used and the calendering parameters may be adjusted for optimum adhesion to the barrier layer. Calendering with an elevated temperature improves the attachment of the top coat layer to the barrier layer, as the particles of the top coat layer are pressed into the partly melted barrier layer without destroying it.

The surface energy of the coated substrate may be modified by subjecting the surface to ultraviolet C radiation having λₘₐₓ = 254 nm, ultraviolet-ozone radiation having λₘₐₓ = 185 and λₘₐₓ = 254 nm, plasma treatment, electron beam treatment or Corona treatment. It is also possible to modify the surface of the barrier layer by subjecting the surface of the barrier layer to ultraviolet C radiation, plasma, electron beam or Corona treatment before coating of the top coat layer. In case the barrier layer is hydrophobic and has a low polarity, it is possible to increase polarity and make the barrier layer surface more hydrophilic.

A functional device can be printed to the coated substrate by using existing printing and coating methods such as inkjet printing, flexographic printing, pad printing, rotogravure printing, offset printing, screen printing, reverse gravure, rod or spin coating. A printed functional device comprises in context of this application printed electric circuits, printed electronics, printed sensors, printed displays or the like. A printed functionality may be easily printed on different kinds of packages or wraps. It may be a simple display or a sensor, which may indicate condition of the packed or wrapped material, or when the package/wrapping was opened. It may also be a product ID or RFID tag that can be utilised in logistics management. Generally, printed functionality according to the present invention may be utilised in flexible displays, intelligent packaging, disposable computers, photovoltaics, different kinds of tags for tracking, inventory or luggage, electronic barcodes and in smart cards.

It is also possible to print to the substrate chemoresistors, such as biosensors or chemical sensors, comprising two electrodes and a functionalised semiconductor or an organic conducting ink. Basically the functionalised material itself can be a conductive ink, an organic conductor, an organic semiconductor or an insulator, dissolved in suitable solvent. The solvent resistance of the barrier layer and the solvent durability of the top coat layer are important for the substrate. The barrier layer preferably withstands organic solvents such as tetrahydrofuran (THF), dimethylformamide (DMF), chloroform, dimethyl sulfoxide (DMSO), ethanol, ethanediol, dichlorobenzene (DCB), chlorobenzene (CB), xylene, toluene, mesitylene, tetraline, ethyl acetate, isopropyl alcohol and hexanol. The barrier layer has also a good acid/base resistance and it preferably withstands acids, such as HCl, acetic acid, and/or bases, such as NaOH.

When an analyte to be detected comes into contact with the printed semiconductor on the coated substrate according to the present invention, the conductivity changes and the change may be detected with a separate device. Suitable devices are, for example, separate analyzers as typically used in lab-on-a-chip applications. The analyte to be detected may be a solid, gas or a liquid, preferably a gas or a liquid. When the analyte is in liquid form the substrate surface preferably withstands it, so that the coated substrate may be immersed to a liquid flow or can be dipped into a liquid. Preferably, the barrier layer is hydrophobic but the pigment and/or mineral particles in the top coat layer increase the surface energy of the substrate making the surface hydrophilic.

After the printed functionality, such as an electric circuit, is printed on the coated substrate according to the present invention, the conducting properties of the circuit may be improved by sintering treatment. This is especially advantageous if the colour comprises silver, as the silver particles melt to form a uniform layer and/or organic compounds are decomposed from the particle surface ensuring a high conductivity.

Sintering may be performed in an oven or by IR-radiation, IR-radiation being preferred. In sintering with IR radiation the heat impacts mainly the substrate surface where also the conducting colour is situated and does not during this short time affect the barrier layer beneath the top coat layer. The IR sintering may also be applied easily to a reel-to-reel process. Sintering by using infra red (IR) radiation may be performed by using gas heated or electrical IR heater devices. The sintering temperature employed may be approximately 900 °C - 1200 °C for gas heated IR devices and up to 2000 °C for electrically heated IR devices. The heat needed depends on many factors, for example, in reel-to-reel processes the speed of the web is an important factor. The higher the speed, the higher temperature is needed for sintering as the contact time with the surface is short. Generally, the parameters used in sintering may be adjusted depending on the used ink and web speed. For example, a sintering temperature around 180 °C may require a treatment time from approximately 5 to 15 seconds, typically around 10 seconds. A sintering temperature around 300 °C may require a treatment time from approximately 1 to 10 seconds, typically around 5 seconds.

### FIGURES

The invention is more closely explained in the following non-limiting schematical drawings and figures:
- Figures 1A - 1C: show schematically examples of layered structures according to some embodiments of the present invention.
- Figure 2: shows a cross-section SEM-image showing the layered substrate structure according to an embodiment of the invention,
- Figure 3: shows a cross-section SEM-image showing the layered substrate structure according to an embodiment of the invention,
- Figure 4: shows schematically an all-printed HIFET transistor according to one embodiment of the invention,
- Figure 5: shows schematically an all-printed HIFET transistor according to another embodiment of the invention, and
- Figure 6: shows schematically an all-printed sensor according to one embodiment of the invention.

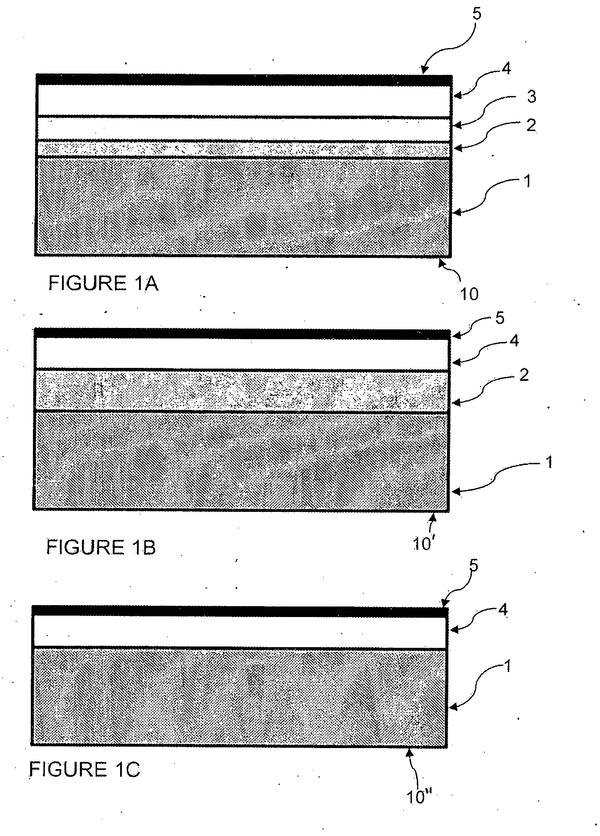

Figures from 1A to 1C show schematically examples of layered structures according to some embodiments of the present invention. In Figure 1A a base web substrate 1 is coated with a pre-coat layer 2. On the pre-coat layer is applied a smoothing layer 3 and on top of that is coated a barrier layer 4. Surface of the substrate 10 is made of a top coat layer 5, coated on the barrier layer 4.

Figure 1B shows another embodiment of a layered substrate 10', where a base web substrate 1 is coated with a pre-coat layer 2. Directly on the pre-coat layer is coated a barrier layer 4. Surface of the substrate 10' is made of a top coat layer 5, coated on the barrier layer 4. No smoothing layer is used.

Figure 1C shows still another embodiment of a layered substrate 10", where a base web substrate 1 is coated directly with a barrier layer 4. Surface of the substrate 10" is made of a top coat layer 5, coated on the barrier layer 4. No pre-coat layer or smoothing layer is used.

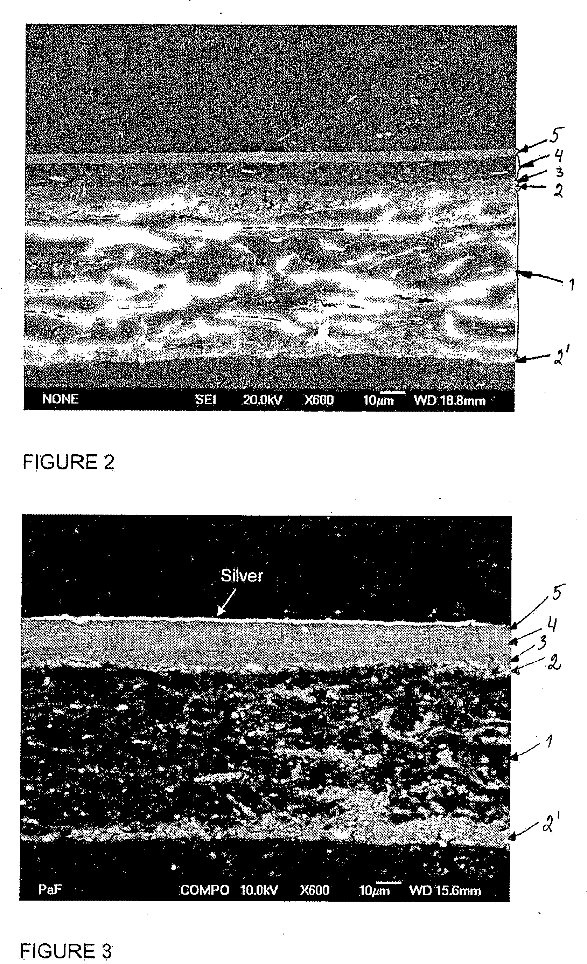

Figure 2 shows a cross-section SEM-image showing the layer structure of a substrate according to an embodiment of the invention. A base paper 1 which is coated with pre-coat layers 2, 2' on both sides is used as base web substrate. The pre-coat layers 2, 2' comprise ground calcium carbonate particles. On the topmost pre-coat layer 2 is coated a smoothing layer 3, comprising kaolin particles in order to obtain as smooth and even surface as possible. The barrier layer 4 is coated on the smoothing layer 3, and a top coat layer 5 is coated on the barrier layer 4. The barrier layer comprises mainly latex and the top coat layer precipitated calcium carbonate or kaolin particles. It can be seen that in this embodiment the barrier layer 4 is clearly thicker than the top coat layer 5, smoothing layer 3 or pre-coat layers 2, 2'. In the embodiment of Fig. 2 the layered structure according to the invention is created only one side of the base web substrate 1. It is clear that similar layered structure may be coated on both sides of the base web substrate if needed, and the layers may be different on different sides of the base web substrate.

Figure 3 shows a cross-section SEM-image showing the layer structure of a substrate according to an embodiment of the invention. A base paper 1 which is coated with pre-coat layers 2, 2' on both sides is used as base web substrate. On the topmost pre-coat layer 2 is coated a smoothing layer 3 in order to obtain as smooth and even surface as possible. The barrier layer 4 is coated on the smoothing layer 3, and a top coat layer 5 is coated on the barrier layer 4. The barrier layer comprises mainly latex blended with mineral particles and the top coat layer precipitated calcium carbonate or kaolin particles. A printed silver ink layer can be observed on top of the top coat layer 5.

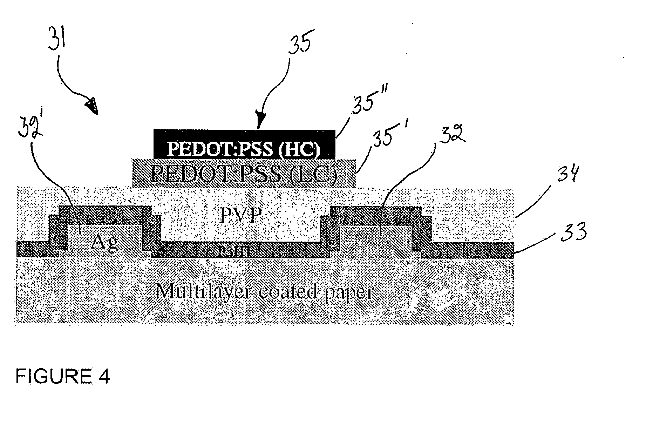

Figure 4 shows schematically an all-printed HIFET transistor according to one embodiment of the invention. The all-printed HIFET transistor 31 comprises silver ink, Ag, for the source 32 and drain 32'. The silver source 32 and drain 32' are covered with a layer 33 of poly-3-hexylthiophene, P3HT, dissolved in dichlorobenzene, which layer 33 functions as semiconductor. This layer 33 of P3HT is covered with a layer 34 of polyvinyl phenol, PVP, which functions as insulator. On the insulator layer 34 is arranged a gate 35 of Poly(3,4-ethylendioxithiophene:poly(styrenesulfonate), PEDOT:PSS. The PEDOT:PSS gate 35 is printed in two layers, 35', 35". The first layer 35' is printed by using alcohol as solvent and the second layer 35" by using water as solvent. The alcohol is preferably used as a solvent in the first gate layer 35' because PVP comprising insulator layer 34 is dissolved in water. In this way it is possible to avoid potential solving of the already printed insulator layer 34 when printing the first gate layer 35', as the solvents of the adjacent layers are not the same. Inkjet print method is employed in the manufacture and the printer is a Dimatix™ Materials Printer (DMP-2800).

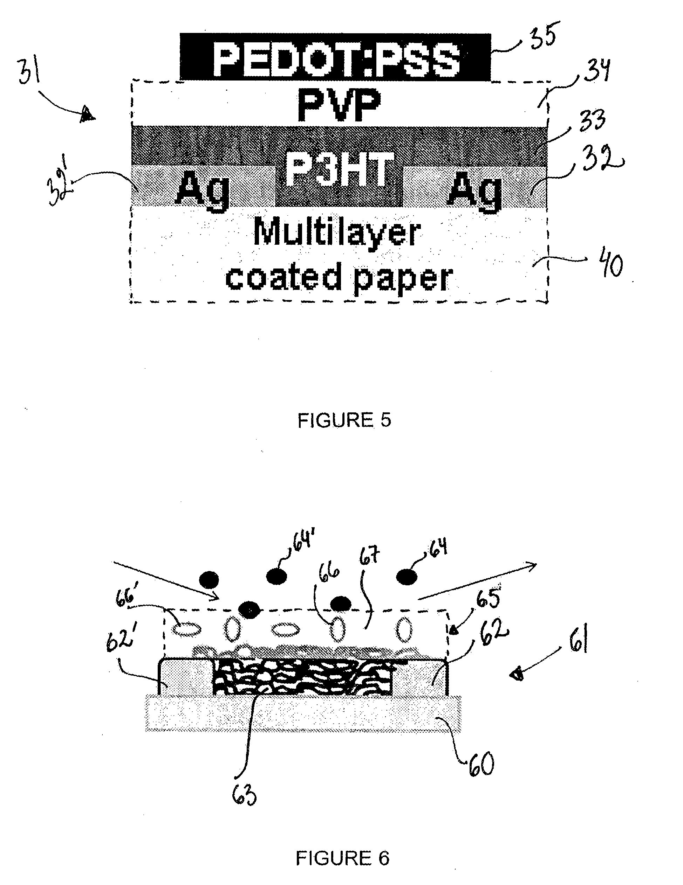

Figure 5 shows schematically an all-printed HIFET transistor according to another embodiment of the invention. The all-printed HIFET transistor 31 comprises silver ink, Ag, for the source 32 and drain 32' printed on a multilayer coated paper 40 according to the present invention. The silver source 32 and drain 32' are covered with a layer 33 of poly-3-hexylthiophene, P3HT, which layer 33 functions as semiconductor. This layer 33 of P3HT is covered with a layer 34 of polyvinyl phenol, PVP, which functions as insulator. On the insulator layer 34 is arranged a gate 35 of Poly(3,4-ethylendioxithiophene:poly(styrenesulfonate), PEDOT:PSS. The PEDOT:PSS gate 35 is printed in one layer. Inkjet print method is employed in the manufacture and the printer is a Dimatix™ Materials Printer (DMP-2800).

Figure 6 shows schematically an all-printed sensor according to one embodiment of the invention. The all-printed sensor 61 comprises silver ink, Ag, for the electrodes 62, 62' printed on a multilayer coated paper 60 according to the present invention. Between the electrodes 62, 62' is arranged a layer 63 of an organic conducting ink or of a conducting polymer, such as polyaniline (PANI). The analyte 64, 64' in buffer reacts with a recognition layer 65, whereby the conductivity of the layer 63 changes. The recognition layer 65 comprises recognition components 66, 66' embedded in a protective matrix 67. The recognition components may be selected from the group comprising different enzymes, antibodies and functional groups, and the protective matrix may be e.g. ion conductive hydrogel. Depending on the function and design of the sensor, the recognition layer including the recognition components and the protective matrix may be omitted. Liquid or gas flow to and from the sensor surface is indicated with the arrows in Fig 6.

## Claims

1. Method for creating a substrate for printed or coated functionality, which comprise printed electric circuits, printed electronics, printed sensors, printed displays or the like, which method comprises
- obtaining a base web substrate (1) comprising cellulose and/or wood fibres,
- coating the base web substrate (1) with a latex or polyolefin dispersion, forming a barrier layer (4) having a thickness of 1 - 25 µm, and comprising latex or polyolefin and 0.1 - 50 weight-% of mineral and/or pigment particles
- coating the barrier layer (4) with a top coat layer (5) comprising 60 - 100 weight-% of mineral and/or pigment particles for improving the printability of the final substrate.

2. Method according to claim 1, **characterised in** controlling the surface energy of the barrier layer (4) by subjecting the barrier layer (4) to energy treatment before coating of the top layer (5) or by controlling the amount of mineral and/or pigment particles in the barrier layer (4).

3. Method according to claim 2, **characterised in** subjecting the surface of the barrier layer (4) to ultraviolet C radiation, plasma, E-beam or Corona treatment before coating of the top layer (5) on the barrier layer (4).

4. Method according to claim 1, 2 or 3, **characterised in** coating the base web substrate (1) with a pre-coat layer (2, 2') and/or smoothing layer (3) before coating it with the barrier layer (4).

5. Method according to any of the claims 1 - 4, **characterised in** controlling the thickness of the top coat layer (5) in order to control the printing properties of the finished substrate.

6. Method according to any of the claims 1 - 5, **characterised in** performing the coating of the different layers as blade coating, rod coating, reverse gravure coating or curtain coating

7. Method according to any of the claims 1 - 6, **characterised in** calendering the substrate after coating of the top coat layer (5).

8. A substrate with a printed or coated functional device, the substrate comprising
- a base web substrate (1) layer comprising cellulose and/or wood fibres,
- a barrier layer (4), coated on the base web substrate (1) layer with a latex or polyolefin dispersion, the barrier layer (4) having a thickness of 1 - 25 µm and comprising latex or polyolefin and mineral and/or pigment particles,
- a top coat layer (5) comprising mineral and/or pigment particles, coated on the barrier layer (4) for improving the printability of the final substrate, wherein
- the barrier layer (4) comprises 0.1 - 50 weight-% mineral and/or pigment particles,
- the top coat layer (5) comprises 60 - 100 weight-% of mineral and/or pigment particles,
- the printed or coated functional device is a printed electric circuit, printed electronics, a printed sensor or a printed display.

9. Substrate according to claim 8, **characterised in that** the top coat layer (5) comprises particles of precipitated calcium carbonate, kaolin, calcinated kaolin, talc, titanium dioxide, gypsum, chalk, satine white, barium sulphate, sodium aluminium silicate, aluminium hydroxide or any of their mixture, preferably kaolin or precipitated calcium carbonate.

10. Substrate according to claim 8 or 9, **characterised in that** the substrate comprises a pre-coat layer (2, 2') and/or smoothing layer (3) arranged between the base web substrate (1) layer and the barrier layer (4).

11. Substrate according to any of the claims 8 - 10, **characterised in that** a functional device is printed and/or coated on the substrate by using printing, such as inkjet printing, flexographic printing, pad printing, rotogravure printing, offset printing, screen printing, or coating, such as reverse gravure coating, blade coating, rod coating, dip coating, drop coating, curtain coating, spray coating, spin coating or embossing.

12. Use of a substrate according to claim 8 in flexible displays, intelligent packaging, disposable computers, photovoltaics, different tags for tracking, inventory or luggage, electronic barcodes and in smart cards.

## Patentansprüche

1. Verfahren zur Erzeugung eines Substrats für gedruckte oder beschichtete Funktionalität, welche gedruckte elektronische Schaltungen, gedruckte Elektronik, gedruckte Sensoren, gedruckte Displays oder dergleichen umfasst, wobei das Verfahren umfasst:
- Erhalten eines Basisgewebesubstrats (1) umfassend Cellulose- und/oder Holzfasern,
- das Beschichten des Basisgewebesubstrats (1) mit einer Latex oder einer Polyolefindispersion, bildend eine Sperrschicht (4) mit einer Dicke von 1-25 µm und umfassend Latex oder Polyolefin und 0,1-50 Gew.-% Mineral- und/oder Pigmentteilchen
- Beschichten der Sperrschicht (4) mit einer Decküberzugsschicht (5) umfassend 60-100 Gew.-% Mineral- und/oder Pigmentteilchen zur Verbesserung der Bedruckbarkeit des finalen Substrats.

2. Verfahren nach Anspruch 1, **gekennzeichnet durch** das Kontrollieren der Oberflächenenergie der Sperrschicht (4) **durch** Unterwerfen der Sperrschicht (4) einer Energiebehandlung vor dem Aufschichten der Deckschicht (5) oder **durch** Kontrollieren der Menge der Mineral- und/oder Pigmentteilchen in der Sperrschicht (4).

3. Verfahren nach Anspruch 2, **gekennzeichnet durch** Unterwerfen der Oberfläche der Sperrschicht (4) einer Ultraviolett-C-Strahlung, einem Plasma, einer E-Beam- oder Coronabehandlung vor dem Aufschichten der Deckschicht (5) auf die Sperrschicht (4).

4. Verfahren nach einem der Ansprüche 1, 2 oder 3, **gekennzeichnet durch** das Beschichten des Basisgewebesubstrats (1) mit einer Vorüberzugsschicht (2, 2') und/oder Glättungsschicht (3) vor dem Beschichten mit der Sperrschicht (4).

5. Verfahren nach einem der Ansprüche 1-4, **gekennzeichnet durch** das Kontrollieren der Dicke der Decküberzugsschicht (5) um die Druckeigenschaften des fertigen Substrats zu kontrollieren.

6. Verfahren nach einem der Ansprüche 1-5, **gekennzeichnet durch** das Durchführen der Aufschichtung von verschiedenen Schichten als Rakelstreichen, Stabstreichen, Gegenlaufgravurstreichen oder Vorhangbeschichten.

7. Verfahren nach einem der Ansprüche 1-6, **gekennzeichnet durch** das Kalandrieren des Substrats nach dem Aufschichten der Decküberzugsschicht (5).

8. Substrat mit einer aufgedruckten oder aufgeschichteten funktionalen Vorrichtung, wobei das Substrat umfasst:
- eine Basisgewebesubstratschicht (1), umfassend Cellulose- und/oder Holzfasern
- eine Sperrschicht (4) aufgeschichtet auf der Basisgewebesubstratschicht (1) mit einer Latex- oder einer Polyolefindispersion, wobei die Sperrschicht (4) eine Dicke von 1-25 µm aufweist und Latex oder Polyolefin und Mineral- und/oder Pigmentteilchen umfasst,
- eine Decküberzugsschicht (5), umfassend Mineral- und/oder Pigmentteilchen, die aufgeschichtet ist auf der Sperrschicht (4) zur Verbesserung der Bedruckbarkeit des fertigen Substrats,
wobei
- die Sperrschicht (4) 0,1-50 Gew.-% Mineral- und/oder Pigmentteilchen umfasst,
- die Decküberzugsschicht (5) 60-100 Gew.-% Mineral- und/oder Pigmentteilchen umfasst,
- die aufgedruckte oder aufgeschichtete funktionale Vorrichtung eine gedruckte elektronische Schaltung, gedruckte Elektronik, ein gedruckter Sensor oder ein gedrucktes Display ist.

9. Substrat nach Anspruch 8, **dadurch gekennzeichnet, dass** die Decküberzugsschicht (5) Teilchen aus gefälltem Calciumcarbonat, Kaolin, calciniertem Kaolin, Talk, Titandioxid, Gips, Kalk, Satinweiß, Bariumsulfat, Natriumaluminiumsilikat, Aluminiumhydroxid oder einem ihrer Gemische, bevorzugt Kaolin oder gefälltem Calciumcarbonat umfasst.

10. Substrat nach einem der Ansprüche 8 oder 9, **dadurch gekennzeichnet, dass** das Substrat eine Vorbeschichtungsschicht (2, 2') und/oder eine Glättungsschicht (3) umfasst, die angeordnet sind zwischen der Basisgewebesubstratschicht (1) und der Sperrschicht (4).

11. Substrat nach einem der Ansprüche 8-10, **dadurch gekennzeichnet, dass** eine funktionale Vorrichtung auf dem Substrat aufgedruckt und/oder aufgeschichtet ist unter Verwendung von Drucken, wie zum Beispiel Tintenstrahldrucken, Flexodruck, Tampondruck, Rotationstiefdruck, Offsetdruck, Siebdruck oder Aufschichten, wie zum Beispiel Gegenlaufgravurstreichen, Rakelstreichen, Stabstreichen, Tauchbeschichten, Tropfbeschichten, Vorhangbeschichten, Sprühbeschichten, Schleuderbeschichten oder Prägen.

12. Verwendung eines Substrats nach Anspruch 8 in flexiblen Displays, intelligenten Verpackungen, Wegwerfcomputern, Photovoltaischen Vorrichtungen, verschiedenen Anhängern für die Nachverfolgung, Inventarisierung oder Gepäck, elektronische Strichcodes und in Smartcards.

## Revendications

1. Procédé permettant de créer un substrat pour une fonctionnalité imprimée ou enrobée, qui comprend les circuits électriques imprimés, les dispositifs électroniques imprimés, les capteurs imprimés, les afficheurs imprimés ou autres, lequel procédé comprend
- l'obtention d'un substrat constitué d'une bande de base (1) comprenant des fibres de cellulose et/ou de bois,
- l'enrobage du substrat constitué d'une bande de base (1) avec une dispersion de latex ou de polyoléfine, pour former une couche barrière (4) ayant une épaisseur de 1 à 25 µm, et comprenant du latex ou une polyoléfine et de 0,1 à 50 % en poids de particules de minéral et/ou de pigment
- l'enrobage de la couche barrière (4) avec une couche d'enrobage supérieure (5) comprenant de 60 à 100 % en poids de particules de minéral et/ou de pigment permettant d'améliorer l'imprimabilité du substrat final.

2. Procédé selon la revendication 1, **caractérisé par** le contrôle de l'énergie de surface de la couche barrière (4) en soumettant la couche barrière (4) à un traitement énergétique avant l'application de la couche supérieure (5) ou par le contrôle de la quantité de particules de minéral et/ou de pigment de la couche barrière (4).

3. Procédé selon la revendication 2, **caractérisé par** l'application d'un traitement de type irradiation d'ultraviolets C, plasma, faisceau électronique ou corona sur la surface de la couche barrière (4) avant l'application de la couche supérieure (5) sur la couche barrière (4).

4. Procédé selon la revendication 1, 2 ou 3, **caractérisé par** l'enrobage du substrat constitué d'une bande de base (1) avec une couche de pré-enrobage (2, 2') et/ou une couche de lissage (3) avant son enrobage avec la couche barrière (4).

5. Procédé selon l'une quelconque des revendications 1 à 4, **caractérisé par** le contrôle de l'épaisseur de la couche d'enrobage supérieure (5) afin de contrôler les propriétés d'impression du substrat fini.

6. Procédé selon l'une quelconque des revendications 1 à 5, **caractérisé par** la réalisation de l'application des différentes couches par couchage à la lame, couchage à la barre, couchage par gravure inversée ou couchage par voile.

7. Procédé selon l'une quelconque des revendications 1 à 6, **caractérisé par** le calandrage du substrat après application de la couche d'enrobage supérieure (5).

8. Substrat comportant un dispositif fonctionnel imprimé ou enrobé, le substrat comprenant
- une couche de substrat constitué d'une bande de base (1) comprenant des fibres de cellulose et/ou de bois,
- une couche barrière (4), appliquée sur la couche de substrat constitué d'une bande de base (1) avec une dispersion de latex ou de polyoléfine, la couche barrière (4) ayant une épaisseur de 1 à 25 µm et comprenant du latex ou une polyoléfine et des particules de minéral et/ou de pigment,
- une couche d'enrobage supérieure (5) comprenant des particules de minéral et/ou de pigment, appliquée sur la couche barrière (4) permettant d'améliorer l'imprimabilité du substrat final,
dans lequel
- la couche barrière (4) comprend de 0,1 à 50 % en poids de particules de minéral et/ou de pigment,
- la couche d'enrobage supérieure (5) comprend de 60 à 100 % en poids de particules de minéral et/ou de pigment,
- le dispositif fonctionnel imprimé ou enrobé est un circuit électrique imprimé, un dispositif électronique imprimé, un capteur imprimé ou un afficheur imprimé.

9. Substrat selon la revendication 8, **caractérisé par le fait que** la couche d'enrobage supérieure (5) comprend des particules de carbonate de calcium précipité, de kaolin, de kaolin calciné, de talc, de dioxyde de titane, de gypse, de craie, de blanc satin, de sulfate de baryum, d'aluminosilicate de sodium, d'hydroxyde d'aluminium ou de l'un quelconque de leurs mélanges, de préférence de kaolin ou de carbonate de calcium précipité.

10. Substrat selon la revendication 8 ou 9, **caractérisé par le fait que** le substrat comprend une couche de pré-enrobage (2, 2') et/ou une couche de lissage (3) agencée entre la couche de substrat constitué d'une bande de base (1) et la couche barrière (4).

11. Substrat selon l'une quelconque des revendications 8 à 10, **caractérisé par le fait qu'**un dispositif fonctionnel est imprimé et/ou appliqué sur le substrat en utilisant une impression, telle qu'une impression par jet d'encre, une impression flexographique, une impression au tampon, une impression par rotogravure, une impression offset, une impression sur écran, ou une application, telle qu'un couchage par gravure inversée, un couchage à la lame, un couchage à la barre, un couchage par immersion, une application au goutte à goutte, un couchage par voile, un couchage par aspersion, un dépôt à la tournette ou un embossage.

12. Utilisation d'un substrat selon la revendication 8 dans les écrans flexibles, l'emballage intelligent, les ordinateurs jetables, les dispositifs photovoltaïques, différentes étiquettes pour le traçage, l'inventaire ou les bagages, les codes-barres électroniques et dans les cartes à puce.
